# DEMANDE DE BREVET EUROPEEN

(11) **EP 1 164 593 A1**
(43) Date de publication de la demande: **19.12.2001**
(21) Numéro de dépôt: 01401426.0
(22) Date de dépôt: 01.06.2001
(51) Int. Cl.: G11C 7/10, G11C 11/4099

(54) **Dispositif de régulation de tension pour cellule de référence d'une mémoire vive dynamique, cellule de référence, mémoire et procédé associé**

(30) Priorité: 13.06.2000 FR 0007521
(71) Demandeur: STMicroelectronics S.A., 92120 Montrouge (FR)
(72) Inventeur: Ferrant, Richard, 38190 Crolles (FR)
(74) Mandataire: Casalonga, Axel

(57) **Abrégé**

Le dispositif 5 de régulation de tension pour cellule de référence 1 d'une mémoire vive dynamique organisée en lignes et en colonnes, comprenant une pluralité de cellules mémoire, comprend au moins une capacité 6 de valeur prédéterminée apte à être déchargée lors d'un accès mémoire.

## Description

L'invention concerne le domaine des cellules mémoires ou points mémoires d'une mémoire vive dynamique (DRAM: dynamic random access memory).

Par opposition aux mémoires vives statiques (SRAM) dans lesquelles l'information mémorisée le reste indéfiniment du moins tant que cette mémoire reste alimentée, les mémoires dynamiques présentent la particularité de nécessiter un rafraîchissement périodique de l'information stockée en raison, notamment, des courants de fuite parasites qui déchargent la capacité de stockage de chaque point mémoire.

Classiquement, les mémoires vives dynamiques sont organisées en lignes et en colonnes de cellules mémoires et comprennent, pour chaque colonne, un dispositif d'amplification de lecture/réécriture de chaque cellule mémoire sélectionnée, ce dispositif comprenant des moyens de précharge permettant de précharger la colonne correspondante de la matrice (communément appelée "ligne de bit" par l'homme du métier) à un niveau de tension choisi et des moyens d'amplification comportant, par exemple, deux inverseurs rebouclés, formant une bascule bistable, formés chacun de deux transistors complémentaires et commandés par deux signaux successifs de lecture et de réécriture.

La plupart des mémoires dynamiques comprennent des cellules de référence permettant d'égaliser les charges dans les lignes de bit et de maximiser l'amplitude moyenne du signal entre le 0 logique et le 1 logique. Les cellules de référence comprennent en général une connexion ou port relié à la ligne de bit et une autre connexion ou port relié à une tension de référence. Le fait d'utiliser des cellules de référence ayant la même valeur de capacité que la cellule mémoire permet d'obtenir exactement la même capacité à chaque noeud lors d'un accès sur une ligne. La valeur de tension qui est stockée dans la cellule de référence est égale à la moitié de la tension de référence. Pour obtenir la même marge de variation pour les deux valeurs binaires 0 logique et 1 logique, la référence doit être réglée au point milieu, c'est-à-dire à la moitié de la tension de référence. Une tension égale à la moitié de la valeur de référence doit donc être préchargée dans la cellule de référence entre deux accès de ligne.

Généralement, on utilise un générateur de tension pourvu de composants actifs. Un tel générateur doit être rapide faute de quoi la durée de précharge aura un effet sur les performances, ce qui signifie que le générateur est de taille importante et consomme beaucoup de courant y compris au ralenti. Le changement du réglage d'un tel générateur est le plus souvent impossible car il n'offre une précision satisfaisante que sur une plage de tension réduite.

L'invention se propose de remédier à ces inconvénients.

L'invention concerne un nouveau moyen pour fournir une tension adéquate à une cellule de référence, économique, polyvalent et à faible consommation d'énergie.

Le dispositif, selon un aspect de l'invention, est destiné à la régulation de tension pour cellule de référence d'une mémoire vive dynamique organisée en lignes et en colonnes, comprenant une pluralité de cellules mémoire. Le dispositif comprend au moins une capacité de valeur prédéterminée apte à être déchargée lors d'un accès mémoire.

De préférence, ladite capacité est apte à être complètement déchargée lors d'un accès mémoire.

Dans un mode de réalisation de l'invention, la valeur de ladite capacité est égale à: C_{cell}*(V_{rcf}-V_{rci})/V_{rci} avec C_{cell} la capacité de la cellule de référence, V_{rcf} la tension de la cellule de référence après un accès mémoire, et V_{rci} la tension de la cellule de référence avant un accès mémoire.

Dans un mode de réalisation de l'invention, le dispositif comprend un premier interrupteur disposé en entrée de ladite capacité pour commander une charge de ladite capacité, un courant de charge étant susceptible de provenir d'une cellule de référence. On peut ainsi obtenir une tension connue avec précision sur la cellule de référence.

Dans un mode de réalisation de l'invention, le dispositif comprend un deuxième interrupteur disposé en sortie de ladite capacité pour commander une décharge de ladite capacité. On peut ramener à zéro la tension aux bornes de ladite capacité.

De préférence, le dispositif comprend une pluralité de capacités existantes sur un circuit intégré.

Avantageusement, le dispositif partage au moins une capacité avec au moins un autre dispositif semblable. Plusieurs dispositifs pourront se partager un certain nombre de capacités.

La cellule de référence, selon un aspect de l'invention, est destinée à une mémoire vive dynamique et comprend un dispositif tel que ci-dessus.

De préférence, la cellule comprend un premier port apte à être relié à une cellule mémoire et un deuxième port relié au dispositif de régulation.

La mémoire, selon un aspect de l'invention, comprend une cellule telle que ci-dessus.

Le procédé, selon un aspect de l'invention, est destiné à la régulation de tension d'une cellule de référence pour mémoire vive dynamique organisée en lignes et en colonnes, comprenant une pluralité de cellules mémoire. On partage une charge entre au moins deux capacités de valeurs prédéterminées lors d'une étape d'initialisation et on décharge l'une des deux capacités lors d'un accès mémoire.

Ainsi, on charge ladite capacité lors du partage de charge et on la décharge lors d'un accès mémoire.

De préférence, la charge que l'on partage provient d'une capacité d'une cellule de référence.

Dans un mode de réalisation de l'invention, on utilise une ou plusieurs capacités existantes d'un circuit intégré.

Dans un mode de réalisation de l'invention, on utilise n capacités pour la régulation de tension de p cellules de référence, avec n différent de p. Chaque cellule de référence bénéficie d'une valeur de capacité égale à la somme des capacités divisée par p. Si les capacités sont de valeurs égales C_{cal}, chaque cellule de référence bénéficie d'une valeur de capacité égale à C_{cal} *n/p.

On obtient ainsi un moyen de génération d'une tension de référence parfaitement adaptée aux cellules de référence, n'occupant qu'une faible surface de silicium et dont la consommation énergétique est quasi nulle.

Un mode de réalisation de l'invention est illustré par les dessins annexés :
- la figure 1 est une vue schématique d'une cellule de référence et d'un dispositif de régulation de tension ; et
- la figure 2 est une vue schématique d'une cellule mémoire.

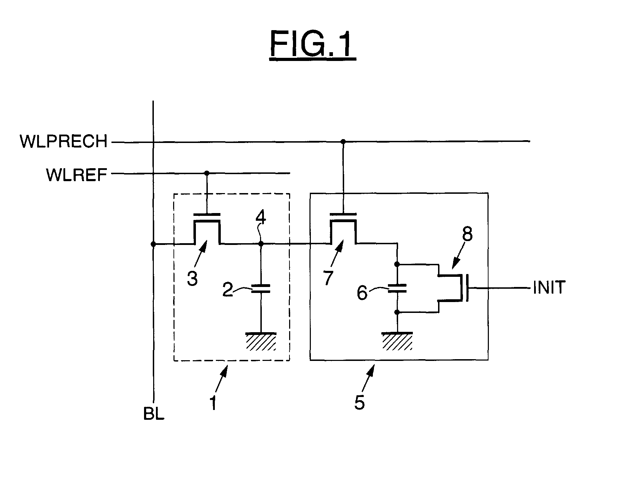

Sur la figure 1, on n'a représenté, à des fins de simplification, qu'une seule cellule de référence 1 comprenant une capacité de stockage 2 et un transistor 3, par exemple du type MOS. L'entrée de commande du transistor 3 est reliée à une ligne de mots recevant un signal WLREF. L'une des deux autres bornes du transistor 3 est reliée à une ligne de bits BL et l'autre est reliée à la capacité 2, l'autre borne de la capacité 2 étant reliée à une masse du circuit. On note 4 le point commun entre le transistor 3 et la capacité 2. Plus généralement, on comprendra que le circuit comprend une cellule de référence 1 par ligne de bits BL.

Un moyen de régulation de la tension de charge de la capacité 2 de la cellule de référence 1 est fourni par le dispositif 5 qui comprend une capacité 6 dont une borne est reliée à une masse du circuit, un transistor 7, par exemple de type MOS, dont une borne est reliée à l'autre borne de la capacité 6 et dont l'autre borne est reliée au point 4 de la cellule de référence 1. L'entrée de commande du transistor 7 est reliée à une ligne de mots apte à recevoir un signal WLPRECH.

Le dispositif 5 comprend en outre un transistor 8, par exemple de type MOS, monté en parallèle de la capacité 6 et dont l'entrée de commande est prévue pour recevoir un signal INIT.

Le fonctionnement du dispositif de régulation 5 et de la cellule mémoire 1 se passe comme suit. Le rôle de la cellule de référence 1 est de maintenir une tension sur la ligne de bit BL. En notant V_{dd} la tension de l'alimentation du circuit, on peut prévoir que la cellule de référence maintienne sur la ligne de bit BL une tension égale à V_{dd}/2.

Avantageusement, pour accroître la sécurité de fonctionnement du circuit, on pourra prévoir de maintenir une tension inférieure, par exemple égale à V_{dd}/3, d'où il découle qu'une tension inférieure à V_{dd}/3 soit considérée comme un niveau logique 0 et qu'une tension supérieure à V_{dd}/3 soit considérée comme une valeur logique 1, la tension égale à V_{dd} x 2/3 étant le niveau logique 1 nominal. Ainsi, la tension présente sur la ligne de bit BL peut s'affaiblir de V_{dd} à V_{dd} x 2/3 et ce sans inconvénient majeur.

La cellule de référence doit donc être préchargée à une valeur de tension égale à V_{dd}/3 entre deux accès de ligne. On note C_{cell} la valeur de la capacité 2, C_{bl} la valeur des capacités de la ligne de bit BL. Le fonctionnement de la mémoire est basé sur un partage de charges entre la ligne de bits BL et la cellule de référence 1. Les valeurs C_{bl} et C_{cell} sont connues avec précision. La ligne de bits BL est préchargée à une tension comprise entre V_{dd}/2 et V_{dd}. Un partage de charges se produit entre la ligne de bits BL et la cellule de référence 1 qui se traduit par une diminution de la tension sur la ligne de bits BL et une augmentation de la tension dans la cellule de référence 1 selon l'équation suivante : V_{b1f} = V_{rcf} = C_{bl}/(C_{bl} + C_{cell})x V_{bli} + C_{cell} /(C_{cell} + C_{bl}) x V_{rci}, avec V_{b1f} la tension finale de la ligne de bits BL, V_{rcf} la tension finale de la cellule de référence 1, V_{bli} la tension initiale de la ligne de bit BL et V_{rci} la tension initiale de la cellule de référence 1.

Pour un fonctionnement convenable, la cellule de référence 1 doit revenir à la tension V_{rci} pour le prochain accès, c'est-à-dire avant que le signal WLREF ne rende passant le transistor 3 de la cellule de référence 1.

Grâce au dispositif de régulation 5, le point 4 formant le second port de la cellule de référence 1 est connecté à la capacité 6 dont la valeur C_{cal} est déterminée avec précision et qui fait l'objet d'une décharge complète durant l'accès. En d'autres termes, les transistors 3 et 8 sont rendus passants sensiblement au même moment tandis que le transistor 7 est bloqué. A un moment où les transistors 3 et 8 sont bloqués, le transistor 7 peut être rendu passant pour permettre un partage de charges entre les capacités 2 et 6. Ce partage de charges est régi par l'équation suivante : V_{rcp} = V_{rci} = C_{cell}/(C_{cell} + C_{cal}) x V_{rcf} + C_{cal}/(C_{cell} + C_{cal}) x 0, avec V_{rcp} la tension de la cellule de référence 1, c'est-à-dire la tension entre le point 4 et la masse du circuit après ce second partage de charges en d'autres termes après que le signal WLPRECH a rendu la transistor 7 passant.

De cette équation, on déduit que : C_{cal} = C_{cell} x (V_{rcf} - V_{rci}) / V_{rci}. Or, tous les termes de la partie de droite de cette équation sont connus avec précision et l'on peut donc calculer la valeur C_{cal}.

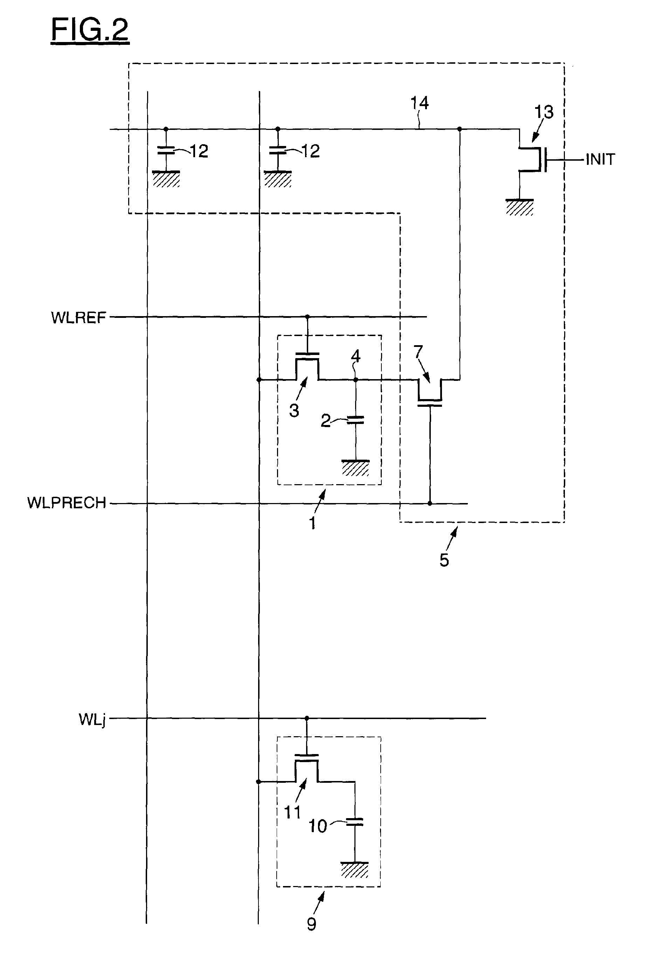

Sur la figure 2, on a représenté une ligne de bit BLᵢ appartenant à une mémoire comprenant une pluralité de lignes de bits. Une cellule mémoire 9 a été représentée connectée à la ligne de bits BLᵢ et également connectée à une ligne de mots WLⱼ. La cellule mémoire 9 comprend une capacité 10 et un transistor 11, par exemple de type MOS, le transistor 11 et la capacité 10 étant disposés en série entre la ligne de bit BLᵢ et une masse du circuit. L'entrée de commande du transistor 11 est reliée à la ligne de mots WLj. Sur cette ligne de bits BLᵢ à laquelle sont reliées une pluralité de cellules mémoires semblables à la cellule 9, est reliée une cellule de référence 1. En d'autres termes, on prévoit une cellule de référence 1 par ligne de bits BL.

Le dispositif de régulation 5 est prévu selon le même principe que dans le mode de réalisation précédent mais réalisé légèrement différemment en partageant une pluralité de capacités 12 et un transistor 13 avec d'autres dispositifs de régulation destinés à d'autres lignes de bit BLₖ, k différent de i. En d'autres termes, à chaque cellule référence 1 est relié un transistor 7 dont la borne de commande est reliée à la ligne de mots WLPRECH et dont l'autre borne est reliée à une ligne 14 à laquelle sont connectées une pluralité de capacités 12 dont l'autre borne est reliée à une masse du circuit. La mise à zéro des capacités 12 est effectuée au moyen d'un transistor 13 monté en parallèle. Ainsi, un unique transistor 13 peut servir à la décharge d'une pluralité de capacités 12.

Ce mode de réalisation est intéressant en ce sens que la valeur C_{cal} que l'on souhaite obtenir peut s'avérer inférieure à C_{cell} voire même inférieure à 25 % de C_{cel} qui est la capacité la plus petite pouvant être réalisée avec une précision convenable. Ainsi, en mettant en commun un nombre n de capacités entre un nombre p de cellules de référence 1, on obtient une capacité de valeur totale égale à n x C_{cal} mais dont les charges se répartissent vers p cellules de référence 1 en passant par p transistors 7 de façon que la charge fournie à une cellule de référence 1 soit égale à la charge que fournirait une capacité unique de valeur C_{cal} que l'on simule en mettant à disposition de chaque cellule de référence 1 une charge correspondant à une capacité de n/p fois la valeur d'une capacité 12. Or, en général, les capacités 12 sont de valeur égale à C_{cel} puisqu'il s'agit du minimum que l'on puisse obtenir avec une précision convenable. Ainsi, on fait bénéficier une cellule de référence 1 d'une valeur de capacité C_{cal} = n/p x C_{cell}. De plus, en mettant en commun ces capacités 12 entre plusieurs cellules de référence, on met également en commun le transistor 13, ce qui permet de réduire le nombre de composants actifs du circuit.

Par ailleurs, les circuits intégrés, notamment les mémoires comprennent généralement une rangée de capacités de valeur C_{cell} disposées en ligne à une extrémité du circuit et ne jouant pas, en règle générale, de rôle particulier. On peut donc se servir de ces capacités inutilisées en tant que capacités de régulation de tension des cellules de référence.

Dans le cas du mode de réalisation de la figure 2 où le nombre n de capacités dont on a besoin est inférieur au nombre p de cellules de référence 1 associées, on utilisera n capacités disposées à une extrémité du circuit et on laissera inutilisées les p - n capacités restantes. Le fait d'utiliser ces capacités d'extrémité de circuit ne change pas de façon importante le procédé de fabrication. La connexion peut être réalisée en changeant un seul masque.

L'invention s'applique particulièrement aux circuits intégrés dont la largeur de gravure est faible et pour lesquels les générateurs de tension sont difficiles à réaliser. L'invention s'applique donc de façon avantageuse à des circuits de largeur 0,18 microns, 0,12 microns, 0,09 microns et de générations futures à lignes de largeur encore réduite. De plus, la consommation d'un tel moyen de régulation de la tension des cellules de référence est extrêmement faible et en tout état de cause inférieure à celles d'un générateur de tension. En pratique, on utilisera entre un cinquième et un tiers des capacités d'extrémité de circuit. A titre d'exemple, on pourra utiliser 27 % ce ces capacités.

En supposant un état initial où tous les signaux sur les lignes de mots sont inactifs, un accès mémoire est effectué lorsque le signal WLⱼ est actif. Simultanément, on active le signal WLREF pour maintenir une tension satisfaisante sur la ligne de bit BL, et le signal INIT pour décharger la capacité 6 de la figure 1 ou les capacités 12 de la figure 2. Après retour à l'état inactif de ces différents signaux, on active le signal WLPRECH qui rend passant le transistor 7 et permet une diminution de la tension des cellules de référence 1 par passage de charges vers la capacité 6 ou les capacités 12. Après une durée déterminée, le signal WLPRECH est ramené à l'état inactif.

## Revendications

1. Dispositif de régulation (5) de tension pour cellule de référence (1) d'une mémoire vive dynamique organisée en lignes et en colonnes, comprenant une pluralité de cellules mémoire, **caractérisé par le fait qu'**il comprend au moins une capacité (6) de valeur prédéterminée apte à être déchargée lors d'un accès mémoire.

2. Dispositif selon la revendication 1, **caractérisé par le fait que** la valeur de ladite capacité est égale à: C_{cell}*(V_{rcf}-V_{rci})/V_{rci} avec C_{cell} la capacité de la cellule de référence, V_{rcf} la tension de la cellule de référence après un accès mémoire, et V_{rci} la tension de la cellule de référence avant un accès mémoire.

3. Dispositif selon la revendication 1 ou 2, **caractérisé par le fait qu'**il comprend un premier interrupteur (7) disposé en entrée de ladite capacité pour commander une charge de ladite capacité, un courant de charge étant susceptible de provenir d'une cellule de référence.

4. Dispositif selon l'une quelconque des revendications précédentes, **caractérisé par le fait qu'**il comprend un deuxième interrupteur (8) disposé en sortie de ladite capacité (6) pour commander une décharge de ladite capacité.

5. Dispositif selon l'une quelconque des revendications précédentes, **caractérisé par le fait qu'**il partage au moins une capacité (12) avec au moins un autre dispositif semblable.

6. Cellule de référence (1) pour mémoire vive dynamique, **caractérisé par le fait qu'**elle comprend un dispositif selon l'une quelconque des revendications précédentes.

7. Cellule selon la revendication 6, **caractérisé par le fait qu'**elle comprend un premier port apte à être relié à une cellule mémoire et un deuxième port relié au dispositif de régulation.

8. Mémoire, **caractérisé par le fait qu'**elle comprend une cellule selon l'une quelconque des revendications 6 ou 7.

9. Procédé de régulation de tension d'une cellule de référence pour mémoire vive dynamique organisée en lignes et en colonnes, comprenant une pluralité de cellules mémoire, dans lequel on partage une charge entre au moins deux capacités de valeurs prédéterminées lors d'une étape d'initialisation et on décharge l'une des deux capacités lors d'un accès mémoire.

10. Procédé selon la revendication 9, dans lequel la charge que l'on partage provient d'une capacité d'une cellule de référence.

11. Procédé selon la revendication 9 ou 10, dans lequel on utilise une ou plusieurs capacités existantes d'un circuit intégré.

12. Procédé selon la revendication 9, 10 ou 11, dans lequel on utilise n capacités pour la régulation de tension de p cellules de référence, avec n différent de p.
